# EUROPEAN PATENT APPLICATION

(11) **EP 2 413 423 A1**
(43) Date of publication of application: **01.02.2012**
(21) Application number: 10755590.6
(22) Date of filing: 04.03.2010
(51) Int. Cl.: H01M 14/00, H01L 31/04

(54) **DYE-SENSITIZED SOLAR CELL AND METHOD FOR MANUFACTURING SAME**

(30) Priority: 23.03.2009 JP 2009070309; 26.06.2009 JP 2009152105
(71) Applicant: Nippon Steel Chemical Co., Ltd., Chiyoda-ku Tokyo 101-0021 (JP); National University Corporation Kyushu Institute Of Technology, Tobata-ku Kitakyushu-shi Fukuoka 804-8550 (JP)
(72) Inventor: HAYASE, Shuzi, Kitakyushu-shi Fukuoka 804-8550 (JP); KUWASAKI, Naoya, Kitakyusyu-shi Fukuoka 804-8503 (JP); KOHNO, Mitsuru, Kitakyusyu-shi Fukuoka 804-8503 (JP); YAMAGUCHI, Yoshihiro, Kitakyusyu-shi Fukuoka 804-8503 (JP)
(74) Representative: Giles, Ashley Simon
(86) International application number: PCT/JP2010/001506
(87) International publication number: WO 2010/109785

(57) **Abstract**

There are provided a dye-sensitized solar cell easy to manufacture, high in power extraction efficiency, and suitable for upsizing, and a method for manufacturing the dye-sensitized solar cell. The dye-sensitized solar cell 10 comprises a transparent substrate 12; a porous semiconductor layer 14 having a dye adsorbed thereto; a conductive metal film 16; and a substrate 20 provided with a conductive film 18 and arranged opposite to the transparent substrate 12. A large number of deep poriform through-holes 24 are irregularly formed in the conductive metal film 16. The dye-sensitized solar cell 10 includes a large number of porous semiconductor particles 25 one end of which is exposed to an electrolyte 22 through the conductive metal film 16 and the other end of which joins the porous semiconductor layer 14.

## Description

### Technical Field

The present invention relates to a dye-sensitized solar cell, and a method for manufacturing the dye-sensitized solar cell.

### Background Art

The dye-sensitized solar cell is called a wet solar cell, Graetzel cell, or the like, and is characterized by having an electrochemical cell structure represented by an iodine solution without using a silicon semiconductor. The dye-sensitized solar cell specifically has a simple structure in which an iodine solution or the like as an electrolyte solution is disposed between a porous semiconductor layer of a titania layer or the like formed by baking titanium dioxide powder or the like on a transparent conductive glass plate (a transparent conductive substrate having a transparent conductive film laminated thereon) and making a dye adsorbed on the baked powder, and a counter electrode composed of a conductive glass plate (conductive substrate).

The dye-sensitized solar cell, since it is inexpensive in terms of its materials and does not need a large-scaled facility for its fabrication, attracts attention as a low-cost solar cell.

The dye-sensitized solar cell is required to be further improved in the conversion efficiency of solar light, and studies have been made from various viewpoints.

As one of the studies, in order to improve the power extraction efficiency by an improvement in the conductivity of an electrode, an attempt has been made in which a transparent conductive film usually formed on a transparent conductive substrate installed on the light incident side is eliminated. This has a great significance especially when a solar cell is made large-sized.

For example, a dye-sensitized solar cell is disclosed in which a transparent conductive film is eliminated; a TiO₂ porous semiconductor layer having a dye adsorbed thereon is directly on a transparent substrate; and Ti is sputtered on the porous semiconductor layer surface to form a perforated Ti thin film as a current collector electrode (see Non Patent Literature 1). The conversion efficiency of solar light of this cell is reportedly 3.6%.

Further for example, a photoelectric converter is disclosed which has a structure having a laminated portion including a semiconductor microparticle layer, a metal net, a charge transfer layer and a counter electrode in this order on a glass substrate, wherein the metal net and the charge transfer layer are directly contacted with each other (see Patent Literature 1).

However, Non Patent Literature 1 makes no mention of the thickness, aperture ratio and the like of a Ti thin film, but in the case where the thickness of the Ti thin film formed by sputtering is extremely thin, for example, about 20 nm, although holes are formed in the Ti thin film formed on irregularities of TiO₂ particles in the porous semiconductor layer surface, the sheet resistivity of the Ti thin film becomes large, which may not lead to a large improvement in the power extraction efficiency. By contrast, if the thickness of the Ti thin film is intended to be made thick, for example, about several hundreds of nanometers, in order to reduce the sheet resistivity of the Ti thin film, holes are not formed in the Ti thin film and the permeation of an electrolyte solution into the porous semiconductor layer is inhibited, which may not function as a solar cell.

A dye-sensitized solar cell of Patent Literature 1 needs a complicated manufacturing method, which may raise the manufacturing cost.

In view of these problems, the inventors have disclosed a dye-sensitized solar cell including a conductive metal film having a large number of through-holes irregularly disposed in the interior of a porous semiconductor layer or on a surface of a transparent substrate opposite to the surface thereof to which light is introduced (Patent Literature 2).

According to this patent literature, the dye-sensitized solar cell can be easily manufactured. In addition, high conversion efficiency can be attained even if the porous semiconductor layer is, for example, thickened.

### Citation List

### Patent Literature

Patent Literature 1: Japanese Patent Laid-Open No. 2007-73505
Patent Literature 2: WO2008/00148

### Non Patent Literature

Non Patent Literature 1: J. M. Kroon, et al., Nanocrystalline Dye-Sensitized Solar Cells Having Maximum Performance, Prog. Photovolt., WileyInterScience, 2006

### Summary of Invention

### Technical Problem

The present invention has been achieved for the purpose of further improving the invention described in Patent Literature 2, and has an object to provide a dye-sensitized solar cell which can simply be manufactured, has a high power extraction efficiency, and is suitable for its upsizing, and to provide a method for manufacturing the dye-sensitized solar cell.

### Solution to Problem

A dye-sensitized solar cell according to the present invention is characterized by including a transparent substrate; a porous semiconductor layer disposed on the transparent substrate and having a dye adsorbed thereto; a conductive metal film disposed in the interior of the porous semiconductor layer or on a surface thereof opposite to the transparent substrate; and a conductive substrate arranged opposite to the transparent substrate, and by having an electrolyte between the conductive metal film and the conductive substrate, wherein the conductive metal film includes a large number of deep poriform through-holes irregularly formed therein and a large number of porous semiconductor particles, one end thereof being exposed to the electrolyte through the conductive metal film and the other end thereof joining the porous semiconductor layer, and is connected to an external electrode.

The dye-sensitized solar cell according to the present invention is **characterized in that** the conductive metal film has preferably a thickness of 100 nm or more.

The dye-sensitized solar cell according to the present invention is **characterized in that** the porous semiconductor particles are preferably an aggregate of particles having a primary particle diameter of 10 to 40 nm, and the size of the aggregate in at least the longitudinal direction thereof is 100 nm or larger.

The dye-sensitized solar cell according to the present invention is **characterized in that** the material of the conductive metal film is preferably a corrosion resistant metal.

The dye-sensitized solar cell according to the present invention is **characterized in that** the corrosion resistant metal is preferably one or two or more selected from tungsten, titanium and nickel, or a compound thereof.

The method for manufacturing a dye-sensitized solar cell according to the present invention, which is a method for manufacturing the above-mentioned dye-sensitized solar cell, comprises:
a mixed layer formation step of forming a mixed layer of a porous semiconductor particle and a microparticle having a shape anisotropy and removable by heating or solvent cleaning, on a porous semiconductor layer;
a conductive metal film formation step of forming a conductive metal film on the mixed layer; and
a microparticle elimination step of eliminating the microparticle by heating or solvent cleaning.

The method for manufacturing a dye-sensitized solar cell according to the present invention, which is a method for manufacturing the above-mentioned dye-sensitized solar cell, comprises:
a mixed layer formation step of forming a mixed layer of a conductive metal particle and a porous semiconductor particle and a microparticle having a shape anisotropy and removable by heating or solvent cleaning, on a porous semiconductor layer; and
a microparticle layer elimination step of eliminating the microparticle by solvent cleaning.

The method for manufacturing a dye-sensitized solar cell according to the present invention preferably further comprises a porous semiconductor layer lamination step of forming another porous semiconductor layer different from the above-mentioned porous semiconductor layer, on the surface of the conductive metal film.

The method for manufacturing a dye-sensitized solar cell according to the present invention is **characterized in that** the microparticle having a shape anisotropy is preferably a microparticle having a large number of legs with vertices of a polyhedron as tips thereof or an acicular microparticle.

### Advantageous Effects of Invention

A dye-sensitized solar cell according to the present invention includes a conductive metal film disposed in the interior of a porous semiconductor layer or on a surface thereof opposite to a transparent substrate, and the conductive metal film includes a large number of deep poriform through-holes irregularly formed therein and a large number of porous semiconductor particles, one end thereof being exposed to an electrolyte through the conductive metal film and the other end thereof joining the porous semiconductor layer. Accordingly, the dye-sensitized solar cell is easy to manufacture, high in power extraction efficiency and, in particular, suitable for upsizing by increasing the thickness of the conductive metal film.

Since the method for manufacturing a dye-sensitized solar cell according to the present invention, which is a method for manufacturing the above-mentioned dye-sensitized solar cell, uses a microparticle having a shape anisotropy and removable by heating or solvent cleaning, for formation of holes in the conductive metal film and uses a mixture of a porous semiconductor particle with a microparticle, the above-mentioned dye-sensitized solar cell can suitably be obtained.

### Brief Description of Drawings

[Figure 1] Figure 1 is a diagram schematically illustrating a sectional structure of the dye-sensitized solar cell according to the embodiment.
[Figure 2(A)] Figure 2(A) is a schematic diagram of a cell member structure to illustrate a manufacturing step in the manufacturing method of a dye-sensitized solar cell according to the embodiment, and is a diagram illustrating a porous semiconductor layer formation step.
[Figure 2(B)] Figure 2(B) is a schematic diagram of a cell member structure to illustrate a manufacturing step in the manufacturing method of a dye-sensitized solar cell according to the embodiment, and is a diagram illustrating a mixed layer formation step.
[Figure 2(C)] Figure 2(C) is a schematic diagram of a cell member structure to illustrate a manufacturing step in the manufacturing method of a dye-sensitized solar cell according to the embodiment, and is a diagram illustrating a conductive metal film formation step.
[Figure 2(D)] Figure 2(D) is a schematic diagram of a cell member structure to illustrate a manufacturing step in the manufacturing method of a dye-sensitized solar cell according to the embodiment, and is a diagram illustrating a microparticle layer elimination step including baking step.
[Figure 2(E)] Figure 2(E) is a schematic diagram of a cell member structure used to illustrate a manufacturing process in the manufacturing method of a dye-sensitized solar cell according to the embodiment, and is a diagram illustrating a microparticle layer elimination step not including a baking step.
[Figure 3] Figure 3 is a drawing illustrating an SEM photograph of a Ti film obtained in Example 1.

### Description of Embodiments

An embodiment of the present invention (hereinafter referred to as the embodiment) will be described hereinafter by way of drawings.

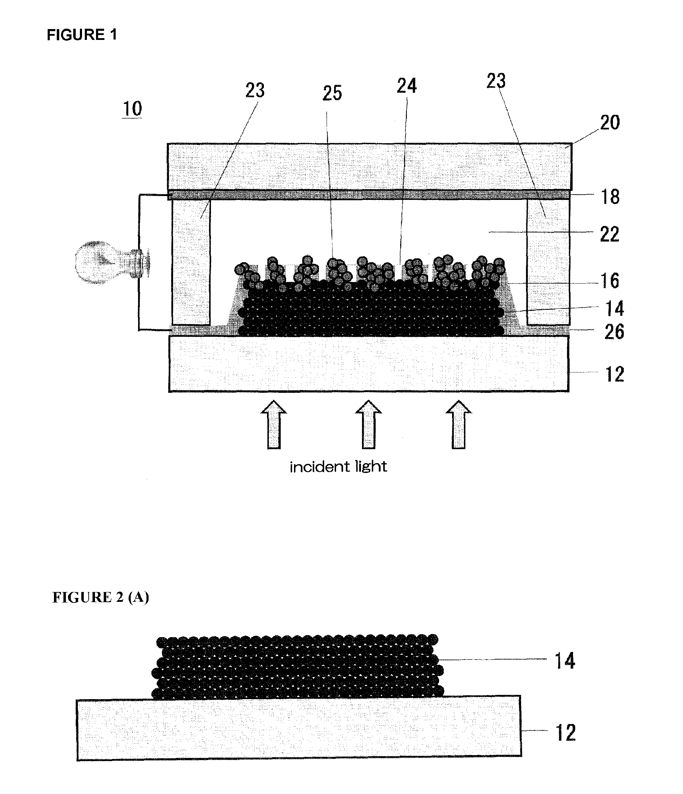

As schematically illustrated, for example, in Figure 1, the dye-sensitized solar cell 10 according to the embodiment comprises a transparent substrate 12, a porous semiconductor layer 14 having a dye adsorbed thereon and disposed on the transparent substrate 12, a conductive metal film 16 disposed on the surface of the porous semiconductor layer 14 on the opposite side to the transparent substrate 12, and a substrate 20 (conductive substrate) disposed opposite to the transparent substrate 12 and having a conductive film 18. The dye-sensitized solar cell 10 further comprises an electrolyte 22 between the conductive metal film 16 and the substrate 20 having the conductive film 18. In Figure 1, reference numeral 23 denotes a spacer installed in order to seal the electrolyte 22 in the cell.

In the conductive metal film 16, a large number of deep poriform through-holes 24 are irregularly formed. Here, the deep poriform through-hole 24 means a deep hole to such a degree that the hole having a relatively small diameter even in the case of a thick conductive metal film 16 securely penetrates through the conductive metal film 16, and refers to a long cylindrical hole having a depth size, for example, several times or several tens of times the size of a hole diameter. In addition, the dye-sensitized solar cell 10 includes a large number of porous semiconductor particles 25 one end of which is exposed to the electrolyte 22 through the conductive metal film 16 and the other end of which joins the porous semiconductor layer 14.

As a material of the porous semiconductor particles 25, a material of the same type as the material of the porous semiconductor layer 14 may be used, or different materials may be used for the semiconductor particles and the semiconductor layer, respectively. Likewise, the diameter of the material used for the porous semiconductor particles 25 may be similar to or the same as the diameter of the material of the porous semiconductor layer 14, or materials different in particle diameter may be used for the semiconductor particles and the semiconductor layer, respectively.

The porous semiconductor particles 25 are not particularly limited in shape. For example, particles having shape anisotropy, such as acicular or cylindroid particles, can be used.

The porous semiconductor particle 25 are preferably prepared so that the size of a group of the particles in at least the longitudinal direction thereof is 100 nm or larger, in order for the particles to be able to securely penetrate through the conductive metal film 16.

For the porous semiconductor particles 25, an aggregate of particles having a primary particle diameter of 10 to 40 nm can be used.

The porous semiconductor particles 25 are preferably baked at a temperature of, for example, 300 to 550°C.

The conductive metal film 16 is electrically connected to an external electrode (current collector electrode) 26 installed on the periphery of the transparent substrate 12. The conductive metal film 16 may be disposed in the interior of the porous semiconductor layer 14. Further, the conductive metal film 16 may be formed in plural numbers alternately with the porous semiconductor layer.

The transparent substrate 12 and the substrate 20 may be, for example, a glass plate or a plastic plate. In the case of using a plastic plate, the plastic plate includes, for example, PET, PEN, polyimide, cured acryl resins, cured epoxy resins, cured silicone resins, various types of engineering plastics, and cyclic polymers obtained by metathesis polymerization.

The transparent substrate 12 may be of a type in which a conductive film the same as a conductive film 18 to be described below is provided on a substrate, such as a glass plate.

The conductive film 18 may be, for example, ITO (tin-doped indium film), FTO (fluorine-doped tin oxide film), or a SnO₂ film. A catalytic film such as, for example, a platinum film, is provided on a surface facing the electrolyte (electrolyte solution) 22 of the conductive film 18.

A dye made adsorbed on the porous semiconductor layer 14 is one having an adsorption at wavelengths of 400 nm to 1,000 nm, and includes, for example, metal complexes such as ruthenium dyes and phthalocyanine dyes, and organic dyes such as cyanine dyes.

The electrolyte (electrolyte solution) 22 contains iodine, lithium ions, an ionic liquid, t-butylpyridine, or the like. For example, in the case of iodine, a redox material composed of a combination of an iodide ion and iodine can be used. The redox material contains a suitable solvent capable of dissolving the redox material.

The thickness of the porous semiconductor layer 14 is not especially limited, but is preferably 14 µm or more.

As one of methods of improving the conversion efficiency of solar light, there is conceivably a method of improving the adsorption efficiency of solar light by making a porous semiconductor layer thick. However, if the electron diffusion length exceeds the thickness size of a porous semiconductor layer, there arises a problem that even if the porous semiconductor layer is made thicker than the length, no effect is exhibited and conversely the open circuit voltage decreases, decreasing the conversion efficiency.

By contrast, according to the dye-sensitized solar cell 10 according to the embodiment, since electrons easily move in the porous semiconductor layer 14 through the conductive metal film 16 functioning as a current collector layer, and the charge transfer resistance from the conductive metal film 16 to the electrolyte 22 is large and the electron reverse movement is hardly caused, a high conversion efficiency can be obtained even if the porous semiconductor layer 14 is made thick, for example, 14 µm or more. In addition, the dye-sensitized solar cell 10 includes a large number of porous semiconductor particles 25 one end of which is exposed to the electrolyte 22 through the conductive metal film 16 and the other end of which joins the porous semiconductor layer 14. Consequently, electron transfer takes place more smoothly, thereby contributing to improvements in power generation efficiency.

The upper limit of the thickness of the porous semiconductor layer 14 is suitably set depending on a value of the conversion efficiency obtained and the like, but is, for example, about 40 µm. The present invention can naturally be applied even to the case where the porous semiconductor layer 14 has a usual thickness.

The porous semiconductor layer 14 is preferably made of a semiconducting material baked at a temperature of 300°C or higher and, more preferably, at a temperature of 450°C or higher. On the other hand, an upper limit of baking temperature is not specified in particular, but is preferably sufficiently lower than the melting point of the material of the porous semiconductor layer 14 and, more preferably, 550°C or lower. If a titanium oxide (titania) is used as the material of the porous semiconductor layer 14, the titanium oxide is preferably baked at such a temperature as not to cause the titanium oxide to make a transition to a rutile crystal, i.e., in a state of anatase crystal in which the conductivity of the titanium oxide is high.

As a semiconductor material for the porous semiconductor layer 14, usable are, for example, oxides of metals such as titanium, tin, zirconium, zinc, indium, tungsten, iron, nickel and silver, but above all, titanium oxide (titania) is more preferable.

A microparticle of titanium oxide includes a small one having a particle diameter of 10 nm or less and a large one having a particle diameter of about 20 to 30 nm. In the case where a film is fabricated using the former microparticle having a small particle diameter, a relatively dense film is made; and by contrast, in the case where a film is fabricated using the latter one having a large particle diameter, a highly porous film is made. Since there are irregularities on the surface of a transparent conductive film such as a tin oxide film, in order to cover the irregularities with high coverage, a relatively dense porous semiconductor layer 14 is desirably used. Hence, the porous semiconductor layer 14 is made of, for example, a two-layer structure; the first layer on the transparent conductive film side is formed of a microparticle of titanium oxide having a small particle diameter; and the second layer formed on the surface of the first layer is formed of a microparticle of titanium oxide having a larger particle diameter than the first layer, which is a preferable embodiment.

The conductive metal film 16 refers to a conductive metal film preferably not having at least a thermal history of a temperature needed to bake the material of the porous semiconductor layer 14 but having a thermal history of a temperature preferably sufficiently lower than 500°C and, more preferably, a temperature of 200°C or lower, or to a conductive metal film not substantially having gone through a heating step. In addition, the porous semiconductor layer 14 preferably has holes communicating with holes penetrating through the conductive metal film 16.

As a conductive metal film 16 usable, a suitable metal is selected as long as it has a reasonable conductivity. Here, the metal includes not only a single metal but a metal compound such as a metal oxide, and an alloy.

The conductive metal film 16 may be coated on the surface of the metal with a dense oxide semiconductor, for example, titania. However, a corrosion resistant metal is more preferably used from the viewpoint of securely preventing the corrosion of the conductive metal film 16 by the electrolyte 22 containing a redox material such as iodine. As a corrosion resistant metal, tungsten (W), titanium (Ti), nickel (Ni) or a mixture thereof, or a metal compound thereof can be suitably used, but besides these, for example, a metal whose surface has been passivated can be used.

The conductive metal film 16 can be formed on the surface of the porous semiconductor layer 14 by a simple method such as coating, but is preferably formed by sputtering. At this time, for example, by previously cutting the end portion and the like of the porous semiconductor layer 14 by a suitable method, a connection part with the external electrode 26 is formed.

The thickness of the conductive metal film 16 is desirably as thick as possible from the viewpoint of making the sheet resistance of the film low, and is preferably 100 nm or more, and more preferably 200 nm or more. The upper limit of the thickness of the conductive metal film 16 is not especially limited, but is, for example, about 5 µm.

Further, the conductive metal film 16 may be formed interposing a porous semiconductor layer therebetween, that is, formed in plural numbers alternately with the porous semiconductor layer.

A method for forming a large number of deep poriform through-holes 24 in the conductive metal film 16 and a method for disposing aculeate porous semiconductor particles will be described later. The through-holes 24 are disposed irregularly and, depending on manufacturing conditions, are formed innumerably. A formation of an appropriate number of through-holes is sufficient, however, as long as the through-holes can adequately penetrate into and pass through the electrolyte 22. The length (depth) of the through-holes 24 is determined according to the thickness of the conductive metal film 16 and is, preferably, 100 nm to 5 µm. The deep poriform through-holes 24 are higher in the diffusibility of the electrolyte 22 into the porous semiconductor layer 14, compared with, for example, such random small holes as described in Non Patent Literature 1. The diameter of each through-hole 24 is not limited in particular, but is preferably 0.1 µm to 5 µm, and more preferably, 0.2 µm to 3 µm.

In the dye-sensitized solar cell according to the present invention, a transparent conductive film usually provided on a transparent substrate is eliminated and a conductive metal film is instead arranged which is disposed in the interior of a porous semiconductor layer or on a surface thereof opposite to the transparent substrate, has a large number of deep poriform through-holes irregularly formed therein, and includes a large number of porous semiconductor particles one end of which is exposed to the electrolyte through the conductive metal film and the other end of which joins the porous semiconductor layer. Accordingly, the dye-sensitized solar cell can be made easy to manufacture, high in power extraction efficiency and, in particular, suitable for upsizing by increasing the thickness of the conductive metal film.

Here, a preferred method for manufacturing a dye-sensitized solar cell according to the embodiment will be described.

The method for manufacturing a dye-sensitized solar cell according to the embodiment comprises: a mixed layer formation step of forming a mixed layer of porous semiconductor particles and microparticles removable by heating or by solvent cleaning and having shape anisotropy on a porous semiconductor layer; a conductive metal film formation step of forming a conductive metal film on the mixed layer; and a microparticle layer elimination step of eliminating the microparticles (microparticles having shape anisotropy) by heating or by solvent cleaning.

Hereinafter, a manufacturing example will be described specifically with reference to Figure 2(A) to Figure 2(D) schematically illustrating manufacturing steps.

First, a material of a porous semiconductor layer 14 is applied on a transparent substrate 12 to form a porous semiconductor layer 14 (see Figure 2(A)). Here, the porous semiconductor layer 14 refers to one obtained by applying the material of a porous semiconductor layer 14, and thereafter baking the applied material.

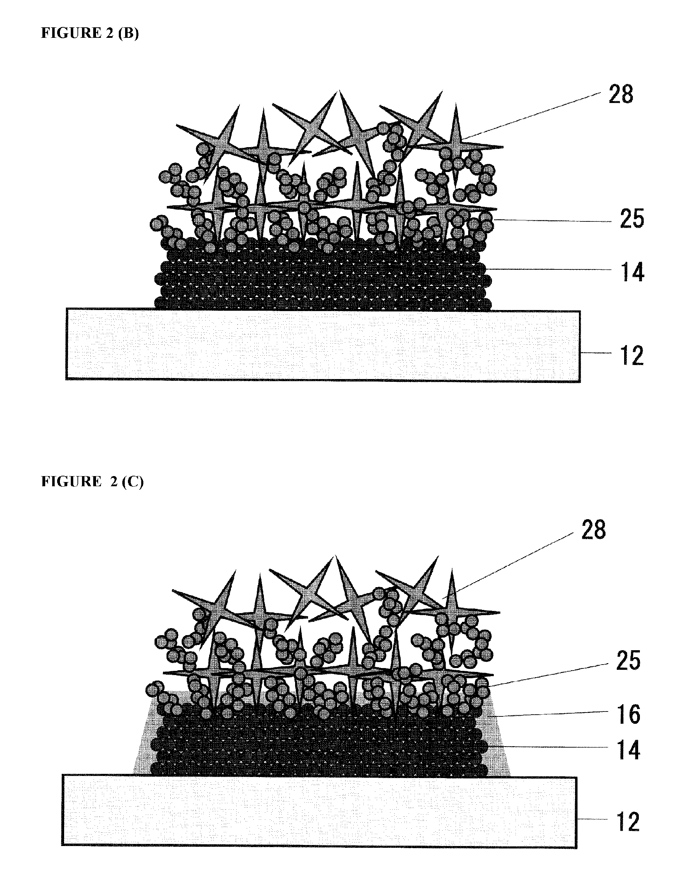

Then, porous semiconductor particles (particles used as a material of the porous semiconductor layer) 25 and microparticles 28 are mixed with each other in order to prepare, for example, a paste-like mixture removable by heating or by solvent cleaning and having shape anisotropy, and dispose the mixture on the porous semiconductor layer 14, thereby forming a mixed layer (mixed layer formation step; see Figure 2(B)). If, for example, a microscopic fibriform material is used independently as the microparticles 28 at this time, the microparticles 28 may form into blocks (granular agglomerates). However, concomitant use of the porous semiconductor particles 25 has the effect of preventing the microparticles from becoming entangled. The mixed layer can be formed by spraying, for example, a slurry of blended materials onto the porous semiconductor layer 14 by using an electrospray. At this time, a baking treatment may be subsequently performed on the mixed layer at a temperature of, for example, approximately 300 to 550°C.

Then, a conductive metal film 16 is formed on the mixed layer (conductive metal film formation step; see Figure 2(C)). At this time, the mixture of the microparticles 28 having shape anisotropy and the porous semiconductor particles 25 penetrates through the conductive metal film 16 and an upper end of the mixture becomes exposed, as illustrated in Figure 2(C). In addition, part of the mixture becomes exposed over the entire range of the conductive metal film 16. Note that for the sake of understanding the invention, Figure 2(C) schematically illustrates the dye-sensitized solar cell 10 as if the thickness of the mixed layer is nearly ten times the thickness of the conductive metal film 16. The mixed layer is sufficiently thick, however, if the thickness thereof is one to several times the thickness of conductive metal film 16.

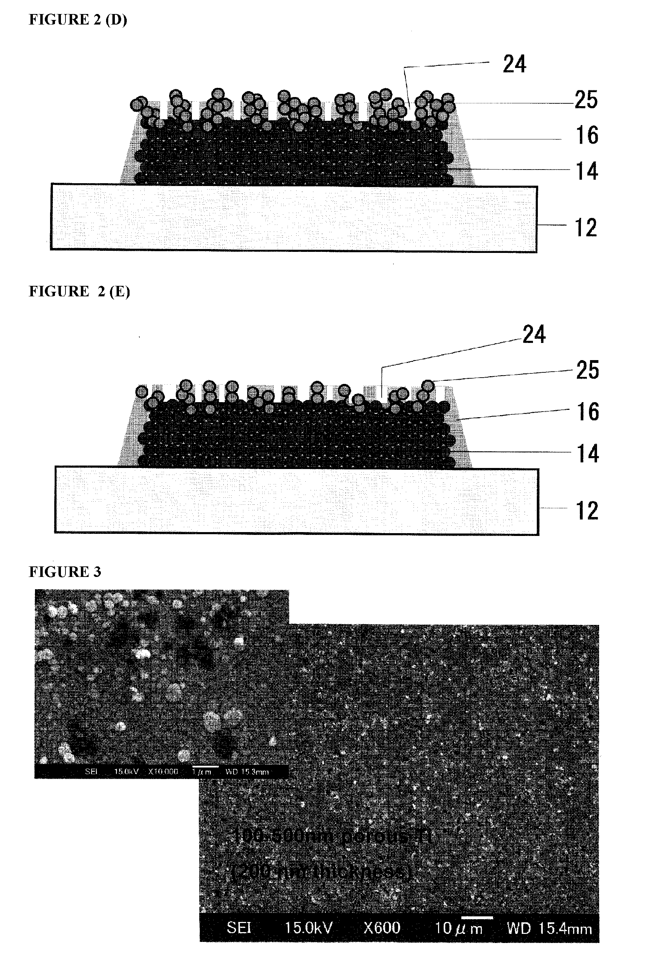

Then, the microparticles 28 are eliminated by heating or by solvent cleaning (microparticle elimination step; see Figures 2(D) and 2(E)). Consequently, a large number of deep poriform through-holes 24 are irregularly formed in the conductive metal film 16. At this time, one end of the porous semiconductor particles 25 which are not eliminated either by heating or by solvent cleaning joins the porous semiconductor layer 14 and the other end thereof is exposed from the conductive metal film 16. Note that if the thickness of the mixed layer is larger than the thickness of the conductive metal film 16, a porous semiconductor particle layer joined to the porous semiconductor particles 25 is partially formed on the conductive metal film 16. The partially formed porous semiconductor particle layer may be left intact or removed by an appropriate method.

Also note that Figure 2(D) illustrates a conductive metal film formation step which includes a step of baking the mixed layer, whereas Figure 2(E) illustrates a conductive metal film formation step which does not include the step of baking the mixed layer.

Then, a dye is attached to the porous semiconductor layer 14.

Further, a substrate 20 having a conductive film 18 is disposed opposite to the transparent substrate 12, and these are sealed with a spacer 23 and an electrolyte 22 is injected to complete a dye-sensitized solar cell 10 (see Figure 1 for reference numerals 10, 18, 20, 22 and 23). As before mentioned in the description of the dye-sensitized solar cell according to the embodiment, the conductive metal film is electrically connected to an external electrode having a suitable structure in a suitable step.

The material of a microparticle 28 to be used is, in the case where the microparticle layer is removed by heating, a material which thermally decomposes and disappears at a temperature of not imposing thermal damage to the layers previously formed such as the porous semiconductor layer 14, and the material is baked at a temperature near the thermal decomposition temperature. The temperature of not imposing thermal damage to layers previously formed such as the porous semiconductor layer 14 is a temperature sufficiently lower than, for example, 500°C, and more preferably about 200°C or lower. Thereby, a thermal influence on the conductive metal film 16, which would be caused if the conductive metal film 16 would be heated at a temperature of, for example, 500°C or higher, is alleviated. In the case where the microparticle layer is removed by solvent cleaning, a combination of a solvent and a microparticle material is used, wherein the solvent does not impose chemical damage to the layers previously formed such as the porous semiconductor layer, and the microparticle material can easily be removed by cleaning using the solvent.

Such a microparticle material is not especially limited, but suitably usable is, for example, a resin such as polystyrene or poly(methyl methacrylate), or a metal oxide such as zinc oxide. A solvent to be used for solvent cleaning is not especially limited, and may be suitably selected in conformance with the microparticle material, and usable are, for example, an organic solvent such as toluene capable of dissolving a resin, and an acid such as dilute hydrochloric acid capable of dissolving a metal.

The microparticle 28 formed of the above-mentioned material to be used has a shape anisotropy. Such a microparticle to be used is preferably a microparticle having a large number of legs with vertices of a polyhedron as tips thereof or an acicular microparticle. The microparticle 28 is not limited to these microparticles, however. For example, an ellipsoidal (e.g., pea-shaped or rugby ball-shaped) microparticle may be used instead.

If a microparticle having a large number of legs with vertices of a polyhedron as tips thereof is used as the microparticle 28, the microparticle preferably has a size whereby the microparticle can securely penetrate through a reasonably thick conductive metal film to be formed on the microparticle and form a hole therein, even when, for example, only one layer of microparticles is sprayed or otherwise onto the porous semiconductor layer. The size of such a microparticle is, for example, 1 to 30 µm, though the size varies depending on the thickness of the conductive metal film.

On the other hand, if an acicular or ellipsoidal microparticle is used as the microparticle 28, spraying the acicular microparticle or the like by, for example, an electrospray method can cause the microparticle to rise on the porous semiconductor layer or remain erected thereon. Hence, the size of such an acicular microparticle or the like is not limited in particular, but is preferably a reasonable length according to the thickness of the conductive metal film 16. In addition, the acicular microparticles or the like are preferably sprayed onto the porous semiconductor layer 14, so as to lie over one another. The size of each acicular microparticle or the like can be the same as the size of the abovementioned microparticle having a large number of legs with vertices of a polyhedron as tips thereof.

Disposing the microparticles 28 having these shape anisotropies on the porous semiconductor layer 14 forms deep holes also in the porous semiconductor layer 14 after the microparticles are eliminated. Then, the permeation and diffusion of an electrolyte 22 in the interior of the porous semiconductor layer 14 is better performed through the deep holes communicating with the above-mentioned holes of the conductive metal film 16.

According to a method for manufacturing a dye-sensitized solar cell according to the embodiment, a relatively stable conductive metal film 16 can easily be formed on a mixed layer by an appropriate method, such as a vapor deposition method or a coating method. In addition, a large number of deep or largely recessed long cylindrical through-holes to be irregularly arranged in the conductive metal film 16 in the course of eliminating and removing microparticles by heating, solvent cleaning or the like can easily be formed.

After the microparticles are eliminated and removed, there can be obtained porous semiconductor particles 25 one end of which joins the porous semiconductor layer 14 and the other end of which is exposed from the conductive metal film 16.

The method for manufacturing a dye-sensitized solar cell according to the embodiment may comprise: a mixed layer formation step of forming a mixed layer of conductive metal particles, porous semiconductor particles, and microparticles removable by heating or by solvent cleaning and having shape anisotropy on the porous semiconductor layer; and a microparticle layer elimination step of eliminating the microparticles by heating or by solvent cleaning.

According to this method, a conductive metal film thus formed is firmly supported by the porous semiconductor particles. In addition, since the mixed layer of conductive metal particles to serve as the conductive metal film, porous semiconductor particles, and microparticles having shape anisotropy is formed in one step, a manufacturing process is simplified.

The method for manufacturing a dye-sensitized solar cell according to the embodiment may further comprise a porous semiconductor layer lamination step of forming another porous semiconductor layer different from the above-mentioned porous semiconductor layer, on the surface of the conductive metal film.

According to the heretofore-mentioned method for manufacturing a dye-sensitized solar cell according to the embodiment, the manufacturing method is simple, and the dye-sensitized solar cell according to the embodiment can suitably be obtained.

### Examples

The present invention will be further described by way of Examples and Comparative Examples. The scope of the present invention is not limited to Examples described hereinafter.

### (Example 1)

A titania paste (one layer of HT Paste and 5 layers of D Paste, made by Solaronics, Inc.) was applied in a thickness of 20 µm on a glass substrate, and baked at 500°C for 30 min to form a titania (titania layer, porous semiconductor layer). A mixed composition slurry of tetrapod-type zinc oxide crystals (trade name: Pana-Tetra, average fiber length of fiber portion: approximately 10 µm, average fiber diameter: approximately 1 µm; made by AMTEC Co., Ltd.) and titanium oxide microparticles (trade name: AEROXIDE (registered trademark) Ti02P25, average primary particle diameter: approximately 20 nm, aggregate size: 200 nm; made by Nippon Aerosil Co., Ltd.) was sprayed onto a titania surface of the baked substrate by an electrospray method. The composition of the mixture was prepared so that a ratio between zinc oxide fibers and titania microparticles was 50 : 50. After the electrospray dispersion, the substrate was baked at 500°C for 30 minutes. Thereafter, a Ti film (Ti layer, 300 nm in film thickness) was formed by a sputtering method. The remaining tetrapod type crystals were removed by rinsing the crystals with dilute hydrochloric acid, thereby fabricating a conductive Ti layer.

Figure 3 shows an SEM photograph of the Ti film thus obtained. A view can be taken of a group of deep poriform through-holes (black portions in Figure 3) formed in the Ti film (background portion in Figure 3) and a group of porous semiconductor particles (white particles or grey particle portions similar to the background in Figure 3) the leading end of which is exposed through the Ti film.

Then, the substrate on which the Ti layer was formed was immersed in a 0.05-wt% dye solution (Black Dye, acetonitrile : t-butylalcohol = 1 : 1, made by Solaronics, Inc.) for 20 hours.

As a counter electrode, used was a fluorine-doped tin oxide glass having been subjected to platinum sputtering (made by Solaronics, Inc.). The substrate on which the Ti layer was formed and the counter electrode were sealed with a spacer (Himilan, made by Du Pont-Mitsui Polychemicals Co., Ltd.) of 50 µm in thickness. An electrolyte solution composed of an acetonitrile solution of iodine of 40 mM, LiI of 500 mM and t-butylpyridine of 580 mM was injected in the obtained cell to fabricate a 5 mm-square cell (a unit cell of a cell).

The fabricated dye-sensitized solar cell was irradiated with a simulated solar light of AM1.5 and 100 mW/cm² using a solar simulator to measure and evaluate solar cell characteristics thereof, obtaining an efficiency of 10.8%.

### (Example 2)

A titania paste (one layer of HT paste and five layers of D paste: made by Solaronics, Inc.) was coated on a glass substrate to a thickness of 20 µm, and baked at 500°C for 30 minutes to form a titania (titania layer and porous semiconductor layer). A mixed composition slurry of tetrapod-type zinc oxide crystals (trade name: Pana-Tetra, average fiber length of fiber portion: approximately 10 µm, average fiber diameter: approximately 1 µm; made by AMTEC Co., Ltd.) and titanium oxide microparticles (trade name: AEROXIDE (registered trademark) Ti02P25, average primary particle diameter: approximately 20 nm, aggregate size: 200 nm; made by Nippon Aerosil Co., Ltd.) was sprayed onto a titania surface of the baked substrate by an electrospray method. The composition of the mixture was prepared so that a ratio between zinc oxide fibers and titania microparticles was 50 : 50. After the electrospray dispersion, the substrate was baked at 500°C for 30 minutes. Thereafter, a Ti film (Ti layer, 300 nm in film thickness) was formed by a sputtering method. The remaining tetrapod type crystals were removed by rinsing the crystals with dilute hydrochloric acid, thereby fabricating a conductive Ti layer.

Figure 3 shows an SEM photograph of the Ti film thus obtained. A view can be taken of a group of deep poriform through-holes (black portions in Figure 3) formed in the Ti film (background portion in Figure 3) and a group of porous semiconductor particles (white particles or grey particle portions similar to the background in Figure 3) the leading end of which is exposed through the Ti film.

Then, the substrate on which the Ti layer was formed was immersed in a 0.05-wt% dye solution (Black Dye, made by Solaronics, Inc., acetonitrile : t-butylalcohol = 1 : 1) for 20 hours.

As a counter electrode, a platinum sputtering-treated fluorine-doped tin oxide glass (made by Solaronics, Inc.) was used. The substrate on which the Ti layer was formed and the counter electrode were sealed with a 50 µm-thick spacer (Himilan, made by Du Pont-Mitsui Polychemicals Co., Ltd.). An electrolyte solution composed of an acetonitrile solution of 40 mM of iodine, 500 mM of LiI and 580 mM of t-butylpyridine was injected into a cell thus obtained, thereby fabricating a 5 mm-square cell (battery cell).

The fabricated dye-sensitized solar cell was irradiated with AM 1.5, 100 mW/cm² simulated solar light by using a solar simulator to measure and evaluate solar cell characteristics of the cell, thus obtaining an efficiency of 10.6%.

### (Comparative Example 1)

A titania paste (one layer of HT Paste and 5 layers of D Paste, made by Solaronics, Inc.) was coated on a glass substrate to a thickness of 20 µm, and baked at 500°C for 30 minutes to form a titania (titania layer and porous semiconductor layer). Tetrapod-type zinc oxide crystals (trade name: Pana-Tetra, average fiber length of fiber portion: approximately 10 µm, average fiber diameter: approximately 1 µm; made by AMTEC Co., Ltd.) were sprayed onto a titania surface of the baked substrate by an electrospray method. Thereafter, a Ti film (Ti layer, 300 nm in film thickness) was formed by a sputtering method. The remaining tetrapod type crystals were removed by rinsing the crystals with dilute hydrochloric acid. Consequently, there was fabricated a porous conductive Ti layer in which a group of deep poriform through-holes formed in the Ti film was arranged. Then, the substrate on which the Ti layer was formed was immersed in a 0.05-wt% dye solution (Black Dye, made by Solaronics, Inc., acetonitrile : t-butylalcohol = 1 : 1) for 20 hours.

As a counter electrode, a platinum sputtering-treated fluorine-doped tin oxide glass (made by Solaronics, Inc.) was used. The substrate on which the Ti layer was formed and the counter electrode were sealed with a 50 µm-thick spacer (Himilan, made by Du Pont-Mitsui Polychemicals Co., Ltd.). An electrolyte solution composed of an acetonitrile solution of 40 mM of iodine, 500 mM of LiI and 580 mM of t-butylpyridine was injected into a cell thus obtained, thereby fabricating a 5 mm-square cell (battery cell).

Solar cell characteristics of the fabricated 5 mm-square solar cell were evaluated by the same method as in Example 1, thus obtaining an efficiency of 9.5%.

### (Comparative Example 2)

A titania paste (one layer of HT Paste and 5 layers of D Paste, made by Solaronics, Inc.) was coated on a glass substrate to a thickness of 20 µm, and baked at 500°C for 30 minutes to form a titania (titania layer and porous semiconductor layer). Titanium oxide microparticles (trade name: AEROXIDE (registered trademark) Ti02P25, average primary particle diameter: approximately 20 nm, aggregate size: 200 nm; made by Nippon Aerosil Co., Ltd.) were sprayed onto a titania surface of the baked substrate by an electrospray method. Thereafter, a Ti film (Ti layer, 300 nm in film thickness) was formed by a sputtering method. Consequently, there was fabricated a conductive Ti layer in which a group of aculeate porous semiconductor particles joining the titania layer (porous semiconductor layer) through the Ti film was arranged.

Then, the substrate on which the Ti layer was formed was immersed in a 0.05-wt% dye solution (Black Dye, made by Solaronics, Inc., acetonitrile : t-butylalcohol = 1 : 1) for 20 hours.

As a counter electrode, a platinum sputtering-treated fluorine-doped tin oxide glass (made by Solaronics, Inc.) was used. The substrate on which the Ti layer was formed and the counter electrode were sealed with a 50 µm-thick spacer (Himilan, made by Du Pont-Mitsui Polychemicals Co., Ltd.). An electrolyte solution composed of an acetonitrile solution of 40 mM of iodine, 500 mM of LiI and 580 mM of t-butylpyridine was injected into a cell thus obtained, thereby fabricating a 5 mm-square cell (battery cell).

Solar cell characteristics of the fabricated 5 mm-square solar cell were evaluated by the same method as in Example 1, thus obtaining an efficiency of 6.0%.

### Reference Signs List

- 10:: Dye-sensitized solar cell
- 12:: Transparent substrate
- 14:: Porous semiconductor layer
- 16:: Conductive metal film
- 18:: Conductive film
- 20:: Substrate
- 22:: Electrolyte
- 23:: Spacer
- 24:: Through-hole
- 25:: Porous semiconductor particle
- 26:: External electrode
- 28:: Microparticle

## Claims

1. A dye-sensitized solar cell comprising:
a transparent substrate;
a porous semiconductor layer disposed on the transparent substrate and having a dye adsorbed thereto;
a conductive metal film disposed in an interior of the porous semiconductor layer or on a surface thereof opposite to the transparent substrate; and
a conductive substrate arranged opposite to the transparent substrate,
and having an electrolyte between the conductive metal film and the conductive substrate,
wherein the conductive metal film includes a large number of deep poriform through-holes irregularly formed therein and a large number of porous semiconductor particles, one end thereof being exposed to the electrolyte through the conductive metal film and the other end thereof joining the porous semiconductor layer, and is connected to an external electrode.

2. The dye-sensitized solar cell according to claim 1, wherein the conductive metal film has a thickness of 100 nm or larger.

3. The dye-sensitized solar cell according to claim 1, wherein the porous semiconductor particles are an aggregate of particles having a primary particle diameter of 10 to 40 nm, and the size of the aggregate in at least the longitudinal direction thereof is 100 nm or larger.

4. The dye-sensitized solar cell according to claim 1, wherein a material of the conductive metal film is a corrosion resistant metal.

5. The dye-sensitized solar cell according to claim 4, wherein the corrosion resistant metal is one selected from the group consisting of tungsten, titanium and nickel, or a compound of two or more thereof.

6. A method for manufacturing a dye-sensitized solar cell according to any one of claims 1 to 5, the method comprising:
a mixed layer formation step of forming a mixed layer of porous semiconductor particles and microparticles removable by heating or by solvent cleaning and having shape anisotropy on a porous semiconductor layer;
a conductive metal film formation step of forming a conductive metal film on the mixed layer; and
a microparticle layer elimination step of eliminating the microparticles by heating or by solvent cleaning.

7. A method for manufacturing a dye-sensitized solar cell according to any one of claims 1 to 5, the method comprising:
a mixed layer formation step of forming a mixed layer of conductive metal particles, porous semiconductor particles, and microparticles removable by solvent cleaning and having shape anisotropy on a porous semiconductor layer; and
a microparticle layer elimination step of eliminating the microparticles by solvent cleaning.

8. The method for manufacturing a dye-sensitized solar cell according to claim 6, further comprising a porous semiconductor layer lamination step of forming another porous semiconductor layer different from the porous semiconductor layer, on a surface of the conductive metal film.

9. The method for manufacturing a dye-sensitized solar cell according to claim 7, further comprising a porous semiconductor layer lamination step of forming another porous semiconductor layer different from the porous semiconductor layer, on a surface of the conductive metal film.

10. The method for manufacturing a dye-sensitized solar cell according to claim 6, wherein the microparticle having a shape anisotropy is a microparticle having a large number of legs with vertices of a polyhedron as tips thereof or an acicular microparticle.

11. The method for manufacturing a dye-sensitized solar cell according to claim 7, wherein the microparticle having a shape anisotropy is a microparticle having a large number of legs with vertices of a polyhedron as tips thereof or an acicular microparticle.

12. The method for manufacturing a dye-sensitized solar cell according to claim 8, wherein the microparticle having a shape anisotropy is a microparticle having a large number of legs with vertices of a polyhedron as tips thereof or an acicular microparticle.

13. The method for manufacturing a dye-sensitized solar cell according to claim 9, wherein the microparticle having a shape anisotropy is a microparticle having a large number of legs with vertices of a polyhedron as tips thereof or an acicular microparticle.
